Europäisches Patentamt

**European Patent Office**

**Office européen des brevets**

(11) Numéro de publication: **0 096 613**
**B1**

## FASCICULE DE BREVET EUROPEEN

(45) Date de publication du fascicule du brevet:
**16.07.86**

(21) Numéro de dépôt: **83401029.0**

(22) Date de dépôt: **24.05.83**

(51) Int. Cl.⁴: **H 01 S 3/19**

(54) **Dispositif semi-conducteur photoémetteur de type laser à guidage par gradient d'indice, et procédé de réalisation d'un tel dispositif.**

(30) Priorité: **04.06.82 FR 8209735**

(43) Date de publication de la demande:
**21.12.83 Bulletin 83/51**

(45) Mention de la délivrance du brevet:
**16.07.86 Bulletin 86/29**

(84) Etats contractants désignés:
**DE GB IT NL SE**

(73) Titulaire: **THOMSON-CSF, 173, Boulevard Haussmann, F-75379 Paris Cedex 08 (FR)**

(72) Inventeur: **de Cremoux, Baudouin, THOMSON-CSF SCPI 173, bld Haussmann, F-75379 Paris Cedex 08 (FR)**
Inventeur: **Blondeau, Robert, THOMSON-CSF SCPI 173, bld Haussmann, F-75379 Paris Cedex 08 (FR)**
Inventeur: **Ricciardi, Jean, THOMSON-CSF SCPI 173, bld Haussmann, F-75379 Paris Cedex 08 (FR)**

(74) Mandataire: **Taboureau, James et al, THOMSON-CSF SCPI 19, avenue de Messine, F-75008 Paris (FR)**

(56) Documents cités:
**FR - A - 2 417 195**

**JAPANESE JOURNAL OF APPLIED PHYSICS, vol. 19, suppl. 19-1, 31 juillet 1980, pages 399-402, Tokyo, JP, M. AYABE et al.: "An improved etched buried heterostructure laser with reduced threshold current"**
**APPLIED PHYSICS LETTERS, vol. 38, no. 8, avril 1981, pages 605-606, American Institute of Physics, New York, USA, K. SHIMA et al.: "Buried convex waveguide structure (GaA1) as injection lasers"**
**ELECTRONICS LETTERS, vol. 17, no. 13, 25 juin 1981, pages 465-467, Hitchin, Herts., GB., H. ISHIKAWA et al.: "V-grooved substrate buried heterostructure InGaAsP/InP laser"**

(56) Documents cités: (suite)
**SOVIET PHYSICS - TECHNICAL PHYSICS, vol. 22, no. 8, août 1977, pages 1032-1036, American Institute of Physics, New York, USA, ZH.I. ALFEROV et al.: "A1-Ga-As heterostructure with confined current flow"**

## Description

La présente invention concerne un dispositif semiconducteur de type laser, à géométrie «ruban» à guidage par l'indice de réfraction, destiné en particulier aux systèmes de télécommunications par fibres optiques. Elle concerne également le procédé de réalisation de ce laser, par épitaxie en phase liquide. La structure étudiée améliore les performances du laser selon l'invention, et en rend la réalisation plus aisée et plus industrielle.

Les lasers à semiconducteurs utilisés comme sources de rayonnement en télécommunications optiques sur fibres de verre ou de silice sont le plus généralement à géométrie dite «ruban», c'est-à-dire qu'ils comportent dans leur structure une région active en forme de ruban, dans laquelle sont confinés les paires électrons-trous de charges électriques, et le rayonnement lumineux. Ces structures peuvent être groupées en deux classes, selon l'effet physique principal qui assure le guidage du rayonnement lumineux le long de l'axe principal du ruban: le gain d'émission stimulée ou l'indice de réfraction effectif.

Dans les lasers à guidage par le gain, la partie réelle de l'indice de réfraction est minimale au centre, ce qui en fait produit un anti-guidage. Par contre, dans les lasers à guidage par l'indice, la partie réelle de l'indice de réfraction est bien maximale au centre du ruban — dans le sens transverse — ce qui assure le guidage, mais leur réalisation est en général assez complexe. En effet, après que la couche active ait été réalisée par épitaxie, il est nécessaire de localiser la région d'injection par des procédés proches de ceux utilisés pour les lasers à guidage par le gain, ce qui complique donc les opérations de réalisation et diminue la définition de la structure puisqu'un plus grand nombre d'opérations et de repérages interviennent dans la fabrication.

Le laser selon l'invention évite ces inconvénients. Il comporte une couche active enterrée, dans laquelle la région d'injection est localisée au cours de l'opération d'épitaxie qui l'a fait croître dans un sillon creusé dans le substrat, et est limitée à la largeur du sillon uniquement. La couche active a, vue en coupe, une forme de croissant dont l'épaisseur est nulle sur les bords, au contact des parois de sillon. Cette structure, selon laquelle la région d'injection est transversalement limitée, est obtenue par une unique opération d'épitaxie en phase liquide à sursaturation nulle, au cours de laquelle la croissance épitaxiale est rapide sur les surfaces concaves et nulle sur les surfaces convexes.

De façon plus précise, l'invention consiste en un dispositif semiconducteur photoémetteur de type laser, dont la lumière est émise par une couche active à géométrie en ruban à l'intérieur de laquelle elle est guidée par un gradient d'indice de réfraction, comportant un substrat, gravé d'un sillon en forme de V, dans lequel est enterrée la couche active du laser, comprise entre deux couches de confinement avec lesquelles elle forme deux hétérojonctions, comportant également une couche de prise de contact déposée sur la couche de confinement externe, et deux métallisations de prises de contacts électriques déposées sur les deux faces principales du substrat, ce laser étant caractérisé en ce que, d'une part, la première couche de confinement, la couche active et la seconde couche de confinement sont limitées à l'intérieur du sillon gravé et en ce que, d'autre part, la face supérieure de la couche de contact, dans le sillon, est au même niveau que la face supérieure du substrat, hors le sillon, la métallisation supérieure de prise de contact, déposée sur la couche de contact, étant isolée du substrat en dehors du sillon.

L'invention sera mieux comprise par la description d'un exemple de réalisation d'un laser à guidage par l'indice, et de son procédé de fabrication, celle-ci s'appuyant sur les figures annexées qui représentent:

figure 1: vue simplifiée d'un laser à semiconducteurs à géométrie ruban,

figure 2: vue en coupe d'un laser à guidage par le gain, selon l'art connu,

figure 3: vue en coupe d'un laser à guidage par l'indice, à hétérostructure enterrée, selon l'art connu,

figure 4: vue en coupe d'un laser à guidage per l'indice, à substrat gravé, selon l'art connu,

figure 5: vue en coupe de laser à guidage par l'indice, selon une première variante de l'invention,

figure 6: autre variante du laser selon l'invention.

Avant d'exposer l'invention, un rappel préliminaire des différentes solutions connues, et de difficultés y afférentes, permettra de mieux cerner l'objet de l'invention et ses avantages.

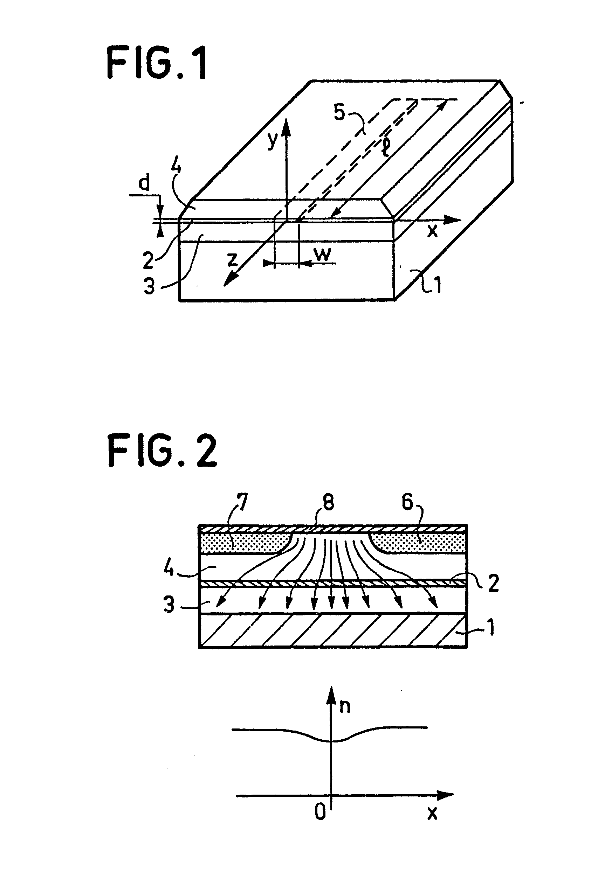

La figure 1 représente une vue simplifiée d'un laser solide à géométrie «ruban», qui est comme cela a été dit, le modèle le plus fréquemment utilisé en conjonction avec les fibres optiques. Divers procédés sont connus pour réaliser ces structures dans lesquelles la région active, où sont confinés à la fois le rayonnement et les paires électron-trou, a la forme d'un ruban.

Un tel laser comprend, supporté par un substrat 1, une couche active 2 limitée par deux couches de confinement 3 et 4 avec lesquelles elle forme deux hétérojonctions. Seul un ruban 5, déterminé dans la couche active 2, doit provoquer l'émission de lumière, de façon à ce que le faisceau soit concentré et guidé.

L'épaisseur «d» de la région active 5 est généralement comprise entre 0,05 et 1 $\mu$m et est déterminée par des hétérojonctions. La longueur «l» est comprise entre 100 et 500 $\mu$m et égale à la distance entre les faces clivées limitant le cristal aux extrémités du ruban 5. Les nombreuses structures à géométrie ruban connues sont relatives au mode de détermination de la largeur «w» de la région active 5 qui peut être comprise entre 1 et 10 $\mu$m pour les lasers de petite puissance pour télécommunications.

Ces structures peuvent être groupées en deux classes suivant l'effet physique principal assurant le guidage du rayonnement suivant la direction $Ox$ transverse du ruban, le guidage selon la direction $Oy$ étant bien assuré par les hétérojonctions.

Le guidage par le gain constitue une première classe de structure, illustrée par la figure 2.

Les mêmes indices de repère sont conservés sur la figure 2, de façon à faciliter le rapprochement avec la figure 1.

Le guidage transverse est dans ce cas assuré par le profil du gain d'émission stimulée, lui-même déterminé par le profil de densité de porteurs injectés qui doit présenter un maximum au centre de la région active. Divers procédés ont été décrits pour arriver à ce résultat. Tous partent d'un dépôt de couches épitaxiales uniformes sur un substrat plan. Ensuite, des moyens empêchant le passage du courant en dehors de la région active sont utilisés. Par exemple, dans le laser de la figure 2, qui comprend, sur un substrat, une couche active 2 limitée par deux couches de confinement 3 et 4, le profil de gain d'emission est déterminé par deux caissons isolants 6 et 7, réalisés dans la couche supérieure de confinement 4. Une métallisation 8 recouvre toute la face extérieure du laser, opposée à celle du substrat 1, mais, en raison des caissons isolants 6 et 7, le profil de densité de porteurs de charges électriques est maximum au centre de la région active. Cette variation de densité est illustrée symboliquement sur la figure 2 par des flèches, denses à proximité de la partie de métallisation 8 en contact avec la couche de confinement 4 et, par voie de conséquence, à proximité de la région centrale de la couche active 2, mais moins denses dans les régions externes de cette même couche active.

La Demanderesse a précédemment réalisé de telles structures par implantation de protons sur une épaisseur d'environ 1 micron, pour rendre les caissons 6 et 7 localement isolants.

Ces structures ont deux inconvénients. D'une part la largeur effective du ruban ne peut être réduite en deçà de quelques microns par suite de la diffusion latérale des porteurs libres injectés dans la région active. D'autre part, le profil de densité de porteurs libres ayant un maximum au centre, il en résulte que la partie réelle de l'indice de réfraction du matériau est minimale, ce qui produit un effet d'anti-guidage et finalement augmente les pertes. Ces deux effets limitent inférieurement la valeur du courant de seuil des lasers vers 40 mA à 0,85 μm de longueur d'onde à l'émission et à plus de 100 mA à 1,3 μm.

Sous la structure de la figure 2 a été juxtaposée une courbe représentant la partie réelle de l'indice de réfraction «n», en fonction de l'abscisse x dans la couche active 2. Cette courbe montre bien que l'indice de réfraction «n» est minimum — pour sa partie réelle — au centre du ruban délimité par le profil de densité.

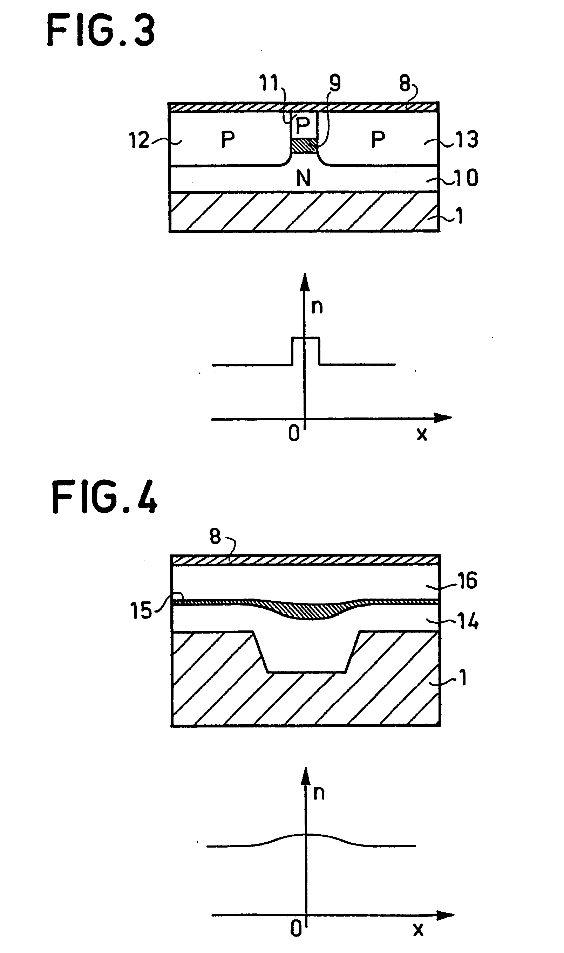

La seconde classe de guidage fait appel à l'indice de réfraction, et est illustré par les figures 3 et 4.

Le guidage transverse est, dans ces structures, dû à un profil de la partie réelle de l'indice de réfraction effectif du guide, présentant par construction un maximum au centre de la région active, nettement supérieur au minimum évoqué précédemment. L'indice de réfraction effectif d'un guide peut être considéré comme une moyenne convenablement pondérée des indices de réfraction des divers matériaux constituant localement ce guide et dépend donc à la fois des matériaux et de la structure. Les structures à guidage par indice décrites jusqu'à présent peuvent être classées en deux types.

Le premier type, illustré en figure 3, concerne les lasers à hétérostructure enterrée.

La zone active 9 de ces lasers est de section rectangulaire et insérée dans une jonction p-n en matériaux à plus grande bande interdite et, par suite d'indice de réfraction plus faible. Le profil transversal de l'indice effectif du guide est donc à saut. Le procédé de réalisation comporte un premier dépôt uniforme de couches épitaxiales 10, 9 et 11 sur un substrat 1, plan. Une opération de photogravure localise alors la région active 9 sous forme de mésa. Un deuxième dépôt épitaxial recouvre ensuite les flancs de cette mésa, par deux caissons 12 et 13: le ruban émetteur 9 est donc enterré, et délimité géométriquement par les deux couches de confinement 10 et 11 et par les deux caissons 12 et 13. Les types de conductivité représentés en figure 3 sont indicatifs, et pourraient être permutés. Une métallisation 8, déposée sur la face libre du laser, permet une prise de contact électrique.

La courbe d'indice de réfraction n, rapportée sous la structure de la figure 3, montre que sa partie réelle présente un maximum.

Le second type de structure à guidage, par gradient d'indice, est à substrat gravé, et est illustré en figure 4.

Sur un substrat 1, dans lequel a été gravé un sillon, on fait croître par épitaxie une première couche 14: celle-ci présente une dépression à l'aplomb du sillon, dans lequel la croissance épitaxiale est plus rapide que sur les parties planes du substrat. Au cours du dépôt épitaxial d'une couche 15, qui est la couche active, il se forme un ménisque dans la dépression de la première couche 14, et donc un maximum d'épaisseur dans la région centrale de la couche active 15. Il en résulte que le profil de l'indice effectif comporte également un maximum, comme le montre la courbe d'indice rapportée sous la structure. On a ainsi un profil à gradient d'indice. Une seconde couche de confinement 16 et une métallisation 8 complètent la structure.

Il est nécessaire ensuite de localiser la région d'injection de courant par un procédé du genre de ceux utilisés pour les lasers à guidage par le gain, par des caissons isolants implantés en surface, car la couche active occupe toute la largeur du dispositif laser.

Les courants de seuils obtenus pour des lasers à guidage par l'indice sont beaucoup plus faibles que des lasers à guidage par la gain: 10 mA au lieu de 40 mA. Ce courant pourrait être encore plus faible si l'on pouvait éliminer le courant de fuite passant dans les jonctions situées de part et d'autre de la région active.

Il est donc particulièrement intéressant que la couche active soit limitée dans le sens transversal, afin d'éviter le courant de fuite latéral qui ne fait qu'abaisser le rendement du laser, en exigeant un courant de seuil plus élevé. Mais il est également souhaitable que la région active soit enterrée, car une telle structure possède une grande durée de vie et une faible résistance thermique.

Une première solution de région active enterrée dans un sillon est décrite dans Applied Physics Letters, vol. 38, n° 8, pages 605-606. Un sillon large, à fond plat, est creusé dans plusieurs couches de GaAs et GaAlAs qui recouvrent un substrat de GaAs. En raison du fond plat du sillon, la région active en GaAlAs est elle-même plate, et la couche de confinement en GaAlAs ainsi que la couche de prise de contact en GaAs qui la recouvrent débordent sur les couches dans lesquelles est creusé le sillon, ce qui crée des courants de fuite latéraux. C'est pour s'opposer à ces courants de fuite latéraux que les types de dopage des couches entourant le sillon sont choisis pour former une diode, polarisée en inverse lorsque le laser est en fonctionnement.

Une seconde solution est décrite dans Electronics Letters, vol. 17, n° 13, pages 465-466. La structure du laser est, dans son ensemble, comparable à celle du laser décrit dans le précédent document, mais le substrat, les couches de confinement et les couches formant diode sont en InP, tandis que la région active est en InGaAsP. L'originalité de cette solution est que le sillon est en forme de V — ce qui communique à la région active une forme de croissant — ce sillon étant creusé selon une orientation <111> B, qui lui communique une surface plus lisse que selon l'orientation <111> A. La croissance épitaxiale des couches est plus reproductible avec une surface orientée <111> B.

Dans les deux cas, la région active, ou ruban de laser, limitée dans un sillon, est surmontée par une couche de confinement et une couche de prise de contact plus larges que le sillon, parce qu'elles en débordent, ce qui nécessite un empilement de couches formant diode, autour du sillon, puisque par ailleurs il n'y a pas de caissons isolants, sous la métallisation de prise de contact, pour délimiter une zone dans laquelle passe le courant, c'est-à-dire limiter latéralement à la région active le courant utile, et supprimer les courants de fuite, hors le sillon.

Cette dernière solution est utilisée dans le laser décrit dans Japanese Journal of Applied Physics, vol. 19, Suppl. 19-1, pages 399-402. La région active de ce laser a une forme incurvée, comprise dans un sillon très évasé, au point qu'il n'est pas possible de dire que la région active est «limitée» dans le sillon, puisqu'elle en suit la courbure jusque sur les bords de la pastille du laser. Pour limiter un ruban émetteur dans cette région active, deux caissons isolants sont implantés sous la métallisation de prise de contact, dont seule la partie centrale est utile: le ruban émetteur de lumière est donc défini, dans une vaste couche active, par la localisation de deux caissons isolants.

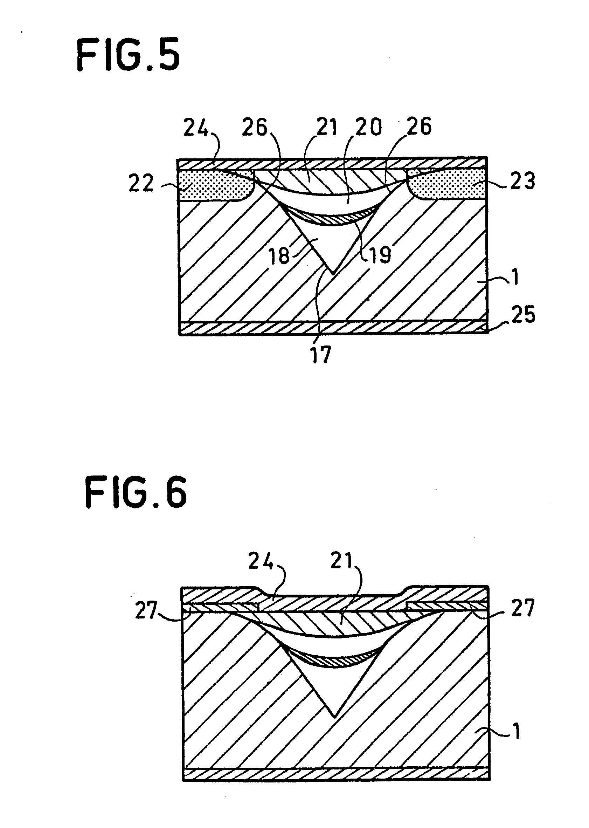

La structure du laser selon l'invention, représenté en figure 5, répond aux impératifs d'une couche active limitée dans le sens transversal afin d'éviter le courant de fuite latéral, et d'une région active enterrée.

Elle est élaborée sur un substrat en InP de type p dopé par du zinc avec une concentration en trous libres voisine de $10^{18}$ cm$^{-3}$. Le phosphore d'indium InP est l'un des substrats les plus couramment utilisés actuellement pour les lasers à l'état solide, mais d'autres types de matériaux, tant pour le substrat que pour les couches de la structure émettrice peuvent être utilisés ainsi que d'autres types de conductivité que ceux qui sont spécifiquement décrits.

Ce substrat 1 comporte un sillon 17, en forme de V, d'ouverture approximative 5 micromètres. C'est dans ce sillon, et seulement dans ce sillon, que l'on fait croître successivement quatre couches épitaxiales.

La première couche 18 est une couche de confinement en InP de type p dopé par du zinc avec une concentration en trous libres comprise entre $10^{17}$ et $10^{18}$ cm$^{-3}$ et d'épaisseur au centre 2 microns. Etant donné que la croissance épitaxiale est plus rapide dans les concavités, la couche 18 a tendance à remplir le fond du sillon en V 17, et sa surface supérieure, à la fin de l'opération d'épitaxie, est en ménisque concave.

Sur cette première couche 18, on fait croître une seconde couche 19, qui constitue la couche actice en $Ga_xIn_{1-x}As_yP_{1-y}$, non dopée dont la composition est choisie de façon que cette solution solide ait un paramètre de maille identique à celui du substrat et que la longueur d'onde d'émission soit de 1,30 µm. On sait que ces conditions sont réunies lorsque

$$x = 0,28 \text{ et } y = 0,60$$

Les conditions d'épitaxie sont ajustées de façon que la couche active ait une forme de croissant, avec une épaisseur au centre comprise entre 0,1 et 0,5 µm et nulle sur les bords. Cette forme s'obtient naturellement puisque l'épitaxie a lieu sur une surface déjà concave, celle de la première couche 18, qui favorise une plus forte croissance au centre de la concavité.

Le laser reçoit une seconde hétérojonction, formée par la seconde couche de confinement 20, en InP de type n dopée par de l'étain avec une concentration en électrons libres supérieure à la concentration en trous libres de la couche 18, mais inférieure à $10^{18}$ cm$^{-3}$. Cette seconde couche de confinement a, elle aussi, une forme de ménisque, puisque sa croissance épitaxique a pris naissance sur la couche active 19, elle-même concave sur sa surface supérieure.

Enfin, une couche de contacte 21 en InP de type n, dopée par de l'étain avec une concentration en électrons libres supérieure à $10^{18}$ cm$^{-3}$ est déposée par dessus la seconde couche de confinement 20. Les conditions d'épitaxie de cette couche sont ajustées de façon que sa surface soit au niveau de celle du substrat, et sensiblement plane.

De parte et d'autre du sillon sont implantés des protons sur une profondeur d'environ 1 µm afin de rendre le matériau isolant ainsi qu'il est bien connu. Les caissons implantés isolants 22 et 23 ont pour effet d'isoler le substrat 1 du contact métallique supérieur en dehors du sillon. En effet, des métallisations 24 et 25 sont déposées sur les faces supérieure et inférieure de la structure pour permettre la prise des contacts électriques.

La structure de laser selon l'invention présente un aspect remarquable dans la forme du sillon 17 et la limitation des couches active et de confinement à l'intérieur de ce sillon.

En effet, le sillon 17 qui est gravé dans le substrat 1 est à l'origine, avant les opérations d'épitaxie, en forme de V, avec des faces planes et présentant donc un angle vif avec la surface supérieure du substrat. Mais, comme cela a été dit précédemment, l'épitaxie se développe plus rapidement dans les régions concaves que dans les régions convexes ou présentant un angle vif convexe, de sorte qu'au cours des différents opérations d'épitaxie nécessaires pour créer les couches du laser, celles-ci se forment préférentiellement dans le sillon, et y sont limitées et enterrées.

Simultanément, l'angle vif formé entre les faces du sillon et la face supérieure du substrat se dissout légèrement à chaque opération dans le bain épitaxique, ce qui fait qu'à la fin de la réalisation du laser, le sillon en V 17 présente une surface arrondie convexe 26 de raccordement avec le plan supérieur du substrat, surface sur laquelle l'épitaxie ne croît pas.

La limitation à l'intérieur du sillon 17 des couches du laser est dûe en particulier à la surface convexe 26 qui relie le sillon au plan supérieur du substrat.

Une première variante à la structure de laser décrite est représentée sur la figure 6: l'isolation entre le substrat 1 et la métallisation supérieure 24 est obtenue par une couche mince 27 d'un isolant comme l'alumine qui remplace les caissons 22 et 23 implantés. Cette couche isolante 27 présente une fenêtre à l'aplomb du sillon, de façon à permettre la prise de contact entre la métallisation supérieure 24 et la couche de contact 21.

Une autre variante possible consiste dans l'inversion des types de conductivité des matériaux, substrat 1 et première couche de confinement 18 étant de type n, seconde couche de confinement 20 et couche de contact 21 étant de type p.

De même, les matériaux cités ne sont pas limitatifs de l'invention, et leur choix correspond à des critères tels que la longueur d'onde à l'émission désirée. Ainsi les matériaux du système $Ga_xAl_{1-x}$ As déposés sur un substrat en GaAs seront choisi pour émettre dans le domaine spectral 0,7-0,9 μm. La condition essentielle à réaliser étant que la largeur de bande interdite de la couche active 19 soit inférieure d'au moins 0,2 eV à celle des couches de confinement 18 et 20 de manière à constituer une structure à double hétérojonction.

Enfin, la couche de contact 21 peut être de composition différente de celle de la couche de confinement 20, de manière à minimiser la résistance de contact. Ainsi, avec les matériaux du système GaAlAs, elle sera avantageusement en GaAs, avec les matériaux du système GaInAsP, elle pourra être en $Ga_{0,47}In_{0,53}As$ de préférence si le substrat est en InP de type n.

Le procédé de réalisation du laser selon l'invention repose, comme cela a été dit, sur l'épitaxie, localisée dans le sillon. Mais, pour que les couches soient effectivement localisées dans le sillon, les conditions de l'épitaxie sont bien précises et correspondent à ce que l'on appelle la sursaturation nulle. Deux techniques d'épitaxie, en phase liquide et en phase vapeur, sont utilisées. Dans tous les cas, la fabrication de lasers est évidemment une opération collective, sur rondelles de substrat réunissant une pluralité de dispositifs.

Dans une première technique, le substrat ne comporte que les sillons préalablement photogravés. Il est placé dans un creuset d'épitaxie liquide à tiroir de type connu, permettant de l'amener successivement sous plusieurs puits contenant des solutions liquides dont les compositions sont choisies en fonction de celle des couches épitaxiales à déposer. L'épitaxie est conduite de façon différente des techniques habituelles. En effet, la composition de chaque solution liquide est ajustée pour que sa température d'équilibre $T_e$ avec un substrat plan soit égale à $\mp$ 0,5°C près de la temperature constante $T_c$ choisie pour la croissance épitaxiale et qui dépend des matériaux considérés (550 à 650°C pour GaInAsP/InP, 750 à 850°C pour GaAlAs/GaAs). Le substrat est alors introduit successivement sous chacune des solutions liquides. La croissance est nulle sur les parties planes du substrat, à l'équilibre, mais est effective dans les sillons dont la concavité est tournée vers le haut, c'est-à-dire vers les puits d'épitaxie, ce qui détermine les profils de couches épitaxiales décrits sur les figures 5 et 6. La croissance se termine avec la couche 21 lorsque la surface arrive au niveau de celle du substrat.

La sursaturation étant définie par $\Delta T = T_e - T_c$, cette technique de croissance est appelée «à sursaturation nulle».

Selon une variante, qui correspond à la réalisation du laser isolé par alumine, le substrat comporte une couche d'alumine ouverte au dessus des sillons, comme sur la figure 6. La technique d'épitaxie est semblable à celle décrite précédemment, cependant, la présence de l'alumine permet d'utiliser une tolérance moins étroite sur la sursaturation.

Les techniques d'épitaxie en phase vapeur sont également utilisées, en particulier celles qui sont au voisinage de l'équilibre thermodynamique et dont il est connu qu'il est possible, en ajustant la composition de la phase vapeur, de passer d'un décapage du substrat à la croissance épitaxiale, et par conséquent d'ajuster la sursaturation.

C'est donc à la sursaturation nulle qu'est dûe la croissance particulière de couches limitées, dans un sillon, pour la réalisation d'un laser à couche active enterrée, dont l'invention est précisée par les revendications suivantes.


**Revendications**

1.Dispositif semiconducteur photoémetteur de type laser, dont la lumière est émise par une couche active à géométrie en ruban à l'intérieur de laquelle elle est guidée par un gradient d'indice de réfraction, comportant un substrat (1), gravé d'un sillon (17) en forme de V, dans lequel est enterrée la couche active (19) du laser, comprise entre deux couches de confinement (18, 20) avec lesquelles elle forme deux hétérojonctions de forme concave dont la concavité est tournée vers la couche de confinement externe (20), la couche active (19) ayant une épaisseur nulle sur ses bords en contact avec le sillon (17), comportant également une couche de prise de contact (21) déposée sur la couche de confinement (20) externe, et deux métallisations (24, 25) de prises de contacts électriques déposées sur les deux faces principales du substrat (1), ce laser étant caractérisé en ce que, d'une part, la première couche de confinement (18), la couche active (19) et la seconde couche de confinement (20) sont limitées à l'intérieur du sillon gravé (17) et en ce que, d'autre part, la face supérieure de la couche de contact (21), dans le sillon (17), est au même niveau que la face supérieure du substrat (1), hors le sillon (17), la métallisation supérieure de prise de contact (24), déposée sur la couche de contact (21), étant isolée du substrat (1) en dehors du sillon (17).

2. Dispositif semiconducteur selon la revendication 1, caractérisé en ce que l'injection de courant dans le laser est limitée à la région du sillon (17) par deux caissons (22, 23), rendus isolants par implantation de protons, lesquels isolent la métallisation supérieure (24) du substrat (1), et s'opposant au courant de fuite latéral, en dehors du sillon (17).

3. Dispositif semiconducteur selon la revendication 1, caractérisé en ce que l'injection de courant dans le laser est limitée à la région du sillon (17) par une couche d'alumine (27), ouverte à l'aplomb du sillon (17), laquelle isole la métallisation supérieure (24) du substrat (1), et s'oppose au courant de fuite latéral, en dehors du sillon (17).

4. Dispositif semiconducteur selon l'une quelconque des revendications 1 à 3, caractérisé en ce que le substrat (1) et la première couche de confinement (18) sont en InP de type n, la couche active (19) est en $Ga_xIn_{l-x}As_yP_{l-y}$, avec x = 0,28 et y = 0,60, la sconde couche de confinement (20) est en InP de type p et la couche de contact est en $Ga_{0,47}In_{0,53}As$ de type p.

5. Dispositif semiconducteur selon l'une quelconque des revendications 1 à 3, caractérisé en ce que le substrat (1) et la première couche de confinement (18) sont en InP de type p, la couche active (19) est en $Ga_xIn_{l-x}P_{l-y}$, avec x = 0,28 et y = 0,60, la seconde couche de confinement (20) et la couche de contact sont en InP de type n.

6. Dispositif semiconducteur selon la revendication 1, caractérisé en ce que le sillon (17) en V présente deux surfaces de raccordement (26) avec la face supérieure du substrat (1) qui sont de forme convexe, leur convexité étant dirigée vers le sillon (17).

7. Procédé de réalisation d'un dispositif semiconducteur de type laser, selon l'une quelconque des revendications 1 à 6, comportant les étapes suivantes:
— creusement dans un substrat (1) d'un sillon en V (17),
— épitaxie, dans le sillon, d'une première couche de confinement (18),
— épitaxie, dans le sillon, d'une couche active (19),
— épitaxie, dans le sillon, d'une deuxième couche de confinement (20),
— épitaxie, dans le sillon, d'un couche de prise de contact (21),
— réalisation, sur la face supérieure du substrat (1), de deux régions isolantes (22, 23) (27), en dehors du sillon (17),
— dépôt d'une première métallisation de prise de contact (24) sur la surface de la couche de contact (21) et sur les régions isolantes (22, 23) (27), et d'une deuxième métallisation de prise de contact (25) sur la surface inférieure du substrat (1),

ce procédé étant caractérisé en ce que les couches active (19), de confinement (18, 20) et de contact (21) sont obtenues par croissance épitaxiale localisée dans le sillon (17), dans des conditions de sursaturation nulle $\Delta T = T_e - T_c$, $T_e$ étant la température d'équilibre du milieu épitaxique avec un substrat plan et $T_c$ étant la température de croissance épitaxiale, la composition du milieu épitaxique, pour la croissance d'une couche, étant choisie pour que $T_e = T_c$, ces conditions assurant une croissance des couches épitaxiques limitées dans le sillon (17).

**Patentansprüche**

1. Laser-Photoemissions-Halbleiteranordnung, deren Leuchten durch eine aktive Schicht mit Bandgeometrie, in deren Innerem es durch einen Gradienten des Brechungskoeffizienten geführt wird, emittiert wird, mit einem Substrat (1), in das eine V-förmige Rille (17) eingraviert ist, in welche die aktive Schicht (19) des Lasers eingesenkt ist, die eingeschlossen ist zwischen zwei Deckschichten (18, 20), mit denen sie zwei konkave Heteroübergänge bildet, deren Höhlung zur äusseren Deckschicht (20) gewandt ist, wobei die aktive Schicht (19) an den die Rille (17) berührenden Kanten die Dicke Null hat, und ferner mit einer auf die äussere Deckschicht (20) auf gelegten Kontaktierungsschicht (21) und zwei auf die beiden Hauptflächen des Substrats (1) aufgelegten Metallisierungen (24, 25) zur elektrischen Kontaktierung, bei der der Laser gekennzeichnet ist dadurch, dass einerseits die erste Deckschicht (18), die aktive Schicht (19) und die zweite Deckschicht (20) auf das Innere der eingesenkten Rille (17) begrenzt sind und dass andererseits die obenliegende Fläche der Kontaktschicht (21) in der Rille (17) auf dem gleichen Niveau wie die obenliegende Fläche des Substrats (1) ausserhalb der Rille (17) liegt, wobei die obenliegende Kontaktierungsmetallisierung (24), die auf die Kontaktschicht (21) aufgebracht ist, ausserhalb der Rolle (17) vom Substrat (1) isoliert ist.

2. Halbleiteranordnung nach Anspruch 1, dadurch gekennzeichnet, dass die Injektion des Stroms in den Laser auf den Bereich der Rille (17) begrenzt ist durch zwei Kästen (22, 23), die durch eine Implantation von Protonen isolierend gemacht sind, wobei sie die obenliegende Metallisierung (24) des Substrats (1) isolieren und sich dem seitlichen Leckstrom ausserhalb der Rille (17) widersetzen.

3. Halbleiteranordnung nach Anspruch 1, dadurch gekennzeichnet, dass die Injektion von Strom in den Laser auf den Bereich der Rille (17) begrenzt ist durch eine senkrecht über der Rille (17) offene Aluminiumschicht (27), die die obenliegende Metallisation (24) des Substrats (1) isoliert und ausserhalb der Rille (17) dem seitlichen Leckstrom widersteht.

4. Halbleiteranordnung nach einem der Ansprüche 1 bis 3, dadurch gekennzeichnet, dass das Substrat (1) und die erste Deckschicht (18) aus n-InP sind, die aktive Schicht (19) aus $Ga_xIn_{1-x}As_yP_{1-y}$ mit x = 0,28 und y = 0,60 ist, die zweite Deckschicht (20) aus p-InP ist und die Kontaktschicht aus p-$Ga_{0,47}In_{0,53}As$ ist.

5. Halbleiteranordnung nach einem der Ansprüche 1 bis 3, dadurch gekennzeichnet, dass das Substrat (1) und die erste Deckschicht (18) aus p-InP sind, die aktive Schicht (19) aus $Ga_xIn_{1-x}P_{1-y}$ mit x = 0,28 und y = 0,60 ist, die zweite Deckschicht (20) und die Kontaktschicht aus n-InP sind.

6. Halbleiteranordnung nach Anspruch 1, dadurch gekennzeichnet, dass die V-förmige Rille (17) zwei konvexe Verbindungsflächen (26) mit der obenliegenden Fläche des Substrats (1) aufweist, wobei die Wölbung zur Rille (17) gerichtet ist.

7. Verfahren zur Herstellung einer Laser-Halbleiteranordnung nach einem der Ansprüche 1 bis 6, das folgende Schritte aufweist:
— Einsenken einer V-förmigen Rille (17) in ein Substrat (1),
— Aufwachsen einer ersten Deckschicht (18) in die Rille,
— Aufwachsen einer aktiven Schicht (19) in die Rille,
— Aufwachsen einer zweiten Deckschicht (20) in die Rille,
— Aufwachsen einer Kontaktierungsschicht (21) in die Rille,
— Herstellung von zwei Isolierbereichen (22, 23) (27) ausserhalb der Rille (17) auf die obenliegende Fläche des Substrats (1),
— Ansetzen einer ersten Kontaktierungsmetallisierung (24) auf die Oberfläche der Kontaktfläche (21) und auf die Isolierbereiche (22, 23) (27) und einer zweiten Kontaktierungsmetallisation (25) auf die untenliegende Fläche des Substrats (1),

wobei das Verfahren dadurch gekennzeichnet ist, dass die aktiven Schichten (19), die Deckschichten (18, 20) und die Kontaktschicht (21) durch ein begrenztes epitaktisches Wachsen in der Rille (17) unter Bedingungen verschwindender Übersättigung $\Delta T = T_e - T_c$ gewonnen werden, wobei $T_e$ die Gleichgewichtstemperatur des epitaktischen Mediums mit einem ebenen Substrat und $T_c$ die Temperatur eines epitaktischen Wachsen ist und die Zusammensetzung des epitaktischen Mediums für das Wachsen in einer Schicht so gewählt wird, dass $T_e = T_c$ und diese Bedingungen ein begrenztes Wachsen der epitaktischen Schichten in der Rille (17) garantieren.

**Claims**

1. Laser-type photoemission semiconductor device whose light is emitted by an active layer with the geometry of a tape, in the interior of which it is guided by a gradient of the refractive index, comprising a substrate (1) engraved with a groove (17) of V shape in which is buried the active layer (19) of the laser, included between two confining layers (18, 20) with which it forms two heterojunctions of concave form whose concavity is turned towards the outer confinement layer (20), the active layer (19) having a thickness zero at its edges in contact with the groove (17), likewise comprising a contacting layer (21) disposed on the outer confinement layer (20) and two metallizations (24, 25) for electrical contacting disposed on the two major faces of the substrate (1), said laser being characterized in that on the one hand the first confinement layer (18), the active layer (19) and the second confinement layer (20) are limited to the interior of the engraved groove (17) and in that on the other hand the upper face of the contact layer (21) in the groove (17) is at the same level as the upper face of the substrate (1) outside the groove (17), the upper contacting metallization (24) disposed on the contact layer (21) being insulated from the substrate (1) outside the groove (17).

2. Semiconductor device according to claim 1, characterized in that the current injection into the laser is limited to the region of the groove (17) by two boxes (22, 23) made insulating by implantation of protons, said boxes insulating the upper metallization (24) of the substrate (1) and opposing the lateral leakage current outside the groove (17).

3. Semiconductor device according to claim 1, characterized in that the injection current into the laser is limited to the region of the groove (17) by an aluminium layer (27) open vertically above the groove (17), said layer insulating the upper metallization (24) of the substrate (1) and opposing the lateral leakage current outside the groove (17).

4. Semiconductor device according to any one of claims 1 to 3, characterized in that the substance (1) and the first confinement layer (18) are of n-type InP, the active layer (19) is of $Ga_xIn_{1-x}As_yP_{1-y}$, with $x = 0,28$ and $y = 0,60$, the second confinement layer (20) is of p-type InP and the contact layer is of p-type $Ga_{0.47}In_{0.53}As$.

5. Semiconductor device according to any one of claims 1 to 3, characterized in that the substrate (1) and the first confinement layer (18) are of p-type InP, the active layer (19) is of $Ga_xIn_{1-x}P_{1-y}$, with $x = 0.28$ and $y = 0.60$, the second confinement layer (20) and the contact layer being of n-type InP.

6. Semiconductor device according to claim 1, characterized in that the V-shaped groove (17) has two connecting faces (26) to the upper face of the substrate (1) which are of convex form, their convexity being directed towards the groove (17).

7. Method of fabricating a laser-type semiconductor device according to any one of claims 1 to 6, comprising the following stages:
— hollowing out a V-shaped groove (17) in a substrate,
— epitaxial growing in the groove of a first confinement layer (18),
— epitaxial growing in the groove of an active layer (19),
— epitaxial growing in the groove of a second confinement layer (20)
— epitaxial growing in the groove of a contacting layer (21),
— formation on the upper face of the substrate (1) of two insulating regions (22, 23) (27) outside the groove (17),
— deposition of a first contacting metallization (24) on the surface of the contact layer (21) and on the insulating regions (22, 23) (27) and of a second contacting metallization (25) on the lower surface of the substrate (1),

said method being characterized in that the active (19), confinement (18, 20) and contact (21) layers are obtained by localized epitaxial growth in the groove (17) under conditions of zero supersaturation $\Delta T = T_e - T_c$, $T_e$ being the equilibrium temperature of the epitaxial medium with a planar substrate and $T_c$ being the temperature of an epitaxial growth, the composition of the epitaxial medium for the growth of a layer being chosen such that $T_e = T_c$, said conditions ensuring a limited growth of the epitaxial layers in the groove (17).

# FIG.1

# FIG.2

# FIG.3

# FIG.4

# FIG.5

# FIG.6